Europäisches Patentamt

European Patent Office

Office européen des brevets

(11) Veröffentlichungsnummer: **0 023 274**
**A1**

(12) **EUROPÄISCHE PATENTANMELDUNG**

(21) Anmeldenummer: **80103702.9**

(22) Anmeldetag: **30.06.80**

(51) Int. Cl.³: **H 04 L 25/16**

(30) Priorität: **27.07.79 CH 6975/79**

(43) Veröffentlichungstag der Anmeldung:
**04.02.81 Patentblatt 81/5**

(84) Benannte Vertragsstaaten:
**AT BE DE FR GB IT NL SE**

(71) Anmelder: **Crypto Aktiengesellschaft**
**Zugerstrasse 42**
**CH-6312 Steinhausen(CH)**

(72) Erfinder: **Stürzinger, Oskar Edwin**
**Kirchmattweg 6**
**CH-6340 Baar(CH)**

(74) Vertreter: **Blum, Rudolf Emil Ernst et al,**
**c/o E. BLUM & CO. Vorderberg 11**
**CH-8044 Zürich(CH)**

(54) Einrichtung zum Übertragen zusätzlicher Information bei gleichbleibender Grundtaktrate in einem Übertragungssystem und Verfahren zum Betrieb der Einrichtung.

(57) Um das Uebertragen zusätzlicher Information bei gleichbleibender Grundtaktrate in einem Uebertragungssystem zu ermöglichen, wird die sendeseitig eingegebene Information, welche in Form digitaler, gleichlanger, durch Trennzeichen begrenzter Impulspakete vorliegt, in einem Kode-Wandler (2) in einen Kode mit ungleichlangen Impulspaketen umgewandelt. Diese werden durch eindeutig erkennbare Trennzeichen getrennt. Derart ist es möglich, im statistischen Mittel weniger Impulse für eine gegebene Meldungslänge zu übertragen. In die so entstehenden Lücken werden mittels einer Mischstufe (5) zusätzliche Impulspakete aus einem Hilfsspeicher (4) eingefügt. Nach der Uebertragung werden diese in einer Trennstufe (9) abgetrennt. Die restlichen Impulspakete werden in einem Kode-Rückwandler (11) in ihre ursprüngliche Form zurückgeführt. Taktgeber (7, 13) sorgen sendeseitig (A) und empfangsseitig (B) für die Einhaltung des Grundtakts. Die zusätzlich übertragene Information wird in einem empfangsseitigen Hilfsspeicher (8) zur weiteren Verarbeitung gespeichert.

./...

Fig. 2

- 1 -

Einrichtung zum Uebertragen zusätzlicher Information bei
gleichbleibender Grundtaktrate in einem Uebertragungssystem und Verfahren zum Betrieb der Einrichtung

Die Erfindung betrifft eine Einrichtung zum Uebertragen zusätzlicher Information bei gleichbleibender Grundtaktrate in einem Uebertragungssystem, wobei die ursprüngliche Information in einem Kode mit digitalen, strukturierten, gleich langen und durch sendeseitig eingegebene Trennzeichen begrenzten Impulspaketen vorliegt, die im statistischen Mittel eine gleichmässige Verteilung der verschiedenen Zustandslagen aufweisen, mit je einem sendeseitigen (A)
und einem empfangsseitigen (B) Gerät, das jedes mindestens
einen Datenempfänger, einen Speicher, einen Datensender sowie einen Taktgeber enthält.

Die heute üblichen elektrischen Datenverarbeitungssysteme verwenden in den meisten Fällen dual organisierte
Impulszüge. Jeder Impuls ist in der Regel gleich lang und
weist entweder den Wert O oder 1 auf. Um beim Empfänger eine gesicherte Auswertung zu gewährleisten, werden meist in
regelmässigen Abständen Referenzsignale, sogenannte Trenn-,
Takt- oder Synchronzeichen eingeschoben, die für den zu
übertragenden Informationsinhalt ohne Bedeutung sind, jedoch dafür sorgen, dass Sender und Empfänger stets im Gleich-

Sb/cj
25.6.1980                                                    EU 1048

lauf arbeiten, und dass der Empfänger die einzelnen Impulspakete als solche sauber erkennen kann.

Diese Takt- oder Trennzeichen müssen sich von den
Informationsimpulsen eindeutig unterscheiden lassen, um
allfällige Phasenfehler zu vermeiden. Beim klassischen
Fernschreiber mit einem 5-Schritt-Kode (CCITT Nr. 2) arbeitet man auf die Weise, dass als Synchronzeichen stets
die Gruppe Stop, Start (1,0) gesendet wird, wobei das Stop-
Signal aber mindestens 1,4 Normschritte lang sein soll.

Bei vollelektrischen Systemen ist es unpraktisch, eine,
von einem Grundtakt abweichende Schrittlänge in den Impulszug einzubeziehen. Man verfährt daher auf andere Weise:

Beim CCITT-Kode Nr. 2 werden in der Regel das Stop-
Zeichen 2 und für das Start-Zeichen 1 Impulsschritt belegt.
Man kann das Taktsignal auch als Folge von 3 gleichartig
polarisierten Zeichen bilden. Ist für genügende Taktgleichheit zwischen Sender und Empfänger gesorgt (z.B. Quarz-gesteuerte Taktgeber) so sind keine weiteren Massnahmen zu
treffen.

Eine solchermassen organisierte Datenübertragungsstrekke ist voll ausgelastet; d.h., solange ein Informationszug
übertragen wird, kann keine weitere Information zusätzlich
übertragen werden, ohne dass die Pulsrate erhöht wird. Eine
Ausnahme bildet die Einrichtung nach CH-Patent 604'432, bei
welcher die erwähnten Trennzeichen als solche als "Reserveplätze" für zusätzliche Information benutzt werden.

Dieses bekannte Vorgehen ist aber nur möglich, wenn
das Format, d.h., die Strukturierung des zu übertragenden
Impulszuges bekannt ist, mit anderen Worten, wenn man weiss,
wo im Impulszug die Trenn- bzw. Synchronzeichen regelmässig
auftauchen, und wenn diese Strukturierung ein für alle Male
feststeht. Steht ein unbekannter Impulszug an, so versagt
das bekannte Prinzip.

Ein ähnliches Verfahren ist in I.E.E.E. Transactions on Information Theory, Band IT-17, No. 4, Juli 1971, beschrieben, wo redundante, d.h. wiederholt auftretende Bitkombinationen ausgeblendet und durch Zusatzdaten ersetzt werden. Dabei spielt sich der Betrieb in einem festen 7-Bit-Raster ab. Ein solches Verfahren ist nur sinnvoll einsetzbar, falls die Art der ausstehenden Information eine statistische Ungleichverteilung der Impulse bewirkt, wie dies bei PCM-Systemen der Fall sein kann, und falls auf die möglichst getreue Reproduktion am Empfangsende wenig Wert gelegt wird. Aus Bell Telephone System Technical Publications, Monograph 4259, September 1965 ist theoretisch bekannt, einzelne Buchstaben oder Silben statistisch zu gewichten und ihnen ungleich lange Impulskodepakete zuzuordnen, um einen vorgegebenen Text mit möglichst geringer Bitzahl darzustellen und zu übertragen. Es geht dabei nicht um eine Kodewandlung, sondern um die Angabe effektiver Kodes zur Darstellung von Text-Information.

In US-PS 3 016 527 ist eine Vorrichtung dargestellt, welche einen Kode variabler Länge erzeugt, dessen dualer Wert der Stellung der entsprechenden Buchstaben im Alphabet entspricht, um eine Sortierung der Information zu erlauben. Wie bei dem oben angegebenen Beispiel wird dabei eine inhaltlich strukturierte Information vorausgesetzt.

Ferner sind Geräte zur Umwandlung von Kodes an sich bekannt, wozu auf US-PS 4 009 257 und FR-PS 1 487 626 verwiesen wird.

Insgesamt gelingt es mit keiner der genannten Lösungen, in einen Impulszug in Form eines Kodes mit gleichlangen, durch Trennzeichen begrenzten Impulspaketen, welche eine statistisch gleichmässige Verteilung der verschiedenen Zustandslagen aufweisen, unter Beibehaltung der Trennzeichen, zusätzliche Information einzuschlaufen.

Es ist die Aufgabe der vorliegenden Erfindung, eine Einrichtung zu schaffen, mittels welcher in einem solchen digitalen, strukturierten Impulszug, der in vorerst unbekannte jedoch untereinander gleiche Blocklängen aufgeteilt ist, zusätzliche Information eingeblendet werden kann, ohne dass die Trennzeichen direkt verändert werden, (wie im erwähnten CH-Patent 604'432), und ohne dass die Pulsrate erhöht zu werden braucht. Es wird dabei vorausgesetzt, dass der Zeitpunkt der Einblendung dieser zusätzlichen Information nicht sehr wichtig ist, indem dieser Zeitpunkt auf Grund der statistischen Verteilung der Impulsarten innerhalb eines gegebenen Zeitraumes durch die Datenkombinationsanlage selber festgelegt wird.

Die genannte Aufgabe wird erfindungsgemäss dadurch gelöst, dass bei der eingangs erwähnten Einrichtung sendeseitig ein Kode-Wandler vorhanden ist, der die sendeseitig eingegebene, ursprüngliche Information in einen Kode umwandelt, der ungleichlange Impulspakete umfasst, jedoch im statistischen Mittel weniger Impulse für eine gegebene Meldungslänge benötigt, dass ferner eine Mischstufe vorhanden ist, die sendeseitig aus einem weiter vorhandenen Hilfsspeicher, nach Massgabe der erzielten Impulseinsparung bei gleichbleibender Grundtaktrate zusätzliche Impulspakete auf die Uebertragungsleitung einschlauft, und dass empfangsseitig eine Trennstufe vorhanden ist, die diese zusätzlich übertragenen Signale ausscheidet und an einen ebenfalls empfangsseitig vorhandenen Hilfsspeicher abgibt, und dass weiter empfangsseitig ein Kode-Rückwandler existiert, der die restlichen, verbleibenden Impulspakete in die ursprüngliche, sendeseitig eingegebene Information zurückverwandelt.

Nachfolgend wird anhand von Ausführungsbeispielen die Erfindung im einzelnen erläutert. In den beiliegenden Figuren zeigt:

Fig. 1 eine Kode-Wandeltabelle einer möglichen Kode-Transformation, und

Fig. 2 Blockdiagramme einer sendeseitigen und einer empfangsseitigen Station.

Die Erfindung beruht auf der Tatsache, dass es möglich ist, durch Kode-Transformation Platz in einem gegebenen Taktraster für zusätzliche Impulse zu schaffen, (sog. Datenkompression).

Dies sei zunächst anhand des Beispiels moderner Bildtelegraphie-Verfahren mit digitaler Uebertragung zur Veranschaulichung näher erläutert.

Bei solchen Uebertragungen, besonders wenn nur zwei-Ton Systeme zur Anwendung gelangen, ist statistisch über einen gewissen Zeitpunkt hinweg gesehen die Verteilung von schwarz und weiss sehr ungleich; der weisse Anteil überwiegt erheblich. Es sind deshalb verschiedene Verfahren bekannt, bei denen eine oder zwei Bildlinien als Pulspakete erfasst und durch Kode-Transformation in ihrer Platzbelegung auf dem gegebenen Taktraster reduziert werden. Es ist dadurch möglich, ohne Erhöhung der Taktrate die Uebertragungszeit für ein Bildtelegramm zu reduzieren (siehe z.B. IEEE "Transactions on Communications" Vol. Com. 25 Nr. 11, Nov. 77). Entsprechende, weltweite Normierungsvorschläge sind zur Zeit beim CCITT (study group XIV) in Behandlung.

Es ist nun gemäss der Erfindung auch möglich, für irgendeinen strukturierten Datenkode, der auf Impulspaketen gleicher Länge beruht, ähnliche Reduzierungen in der Platzbelegung zu realisieren. Natürlich wird dabei nicht eine so drastische Kompression möglich sein, wie beim oben erwähnten Beispiel, da bei der Datenübertragung die Pulspaketkode in der Regel eine 50%-ige Verteilung der zwei Zustandslagen aufweisen, wenn das statistische Mittel über einen längeren Zeitraum hinweg genommen wird. Andererseits ist es gerade diese Tatsache, dass über einen längeren Zeitraum hinweg jedes mögliche Pulspaket mindestens einmal auftauchen wird, die eine Kompression realisieren lässt.

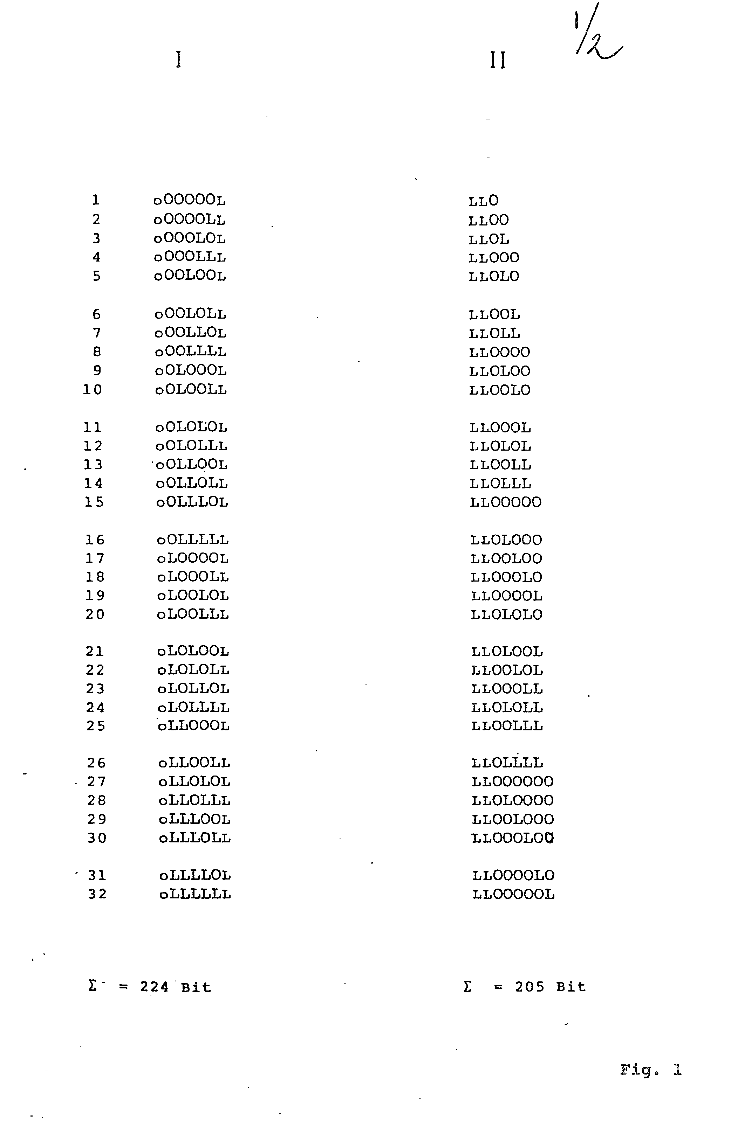

In Fig. 1 ist eine Kode-Wandeltabelle dargestellt, in der eine solcherweise mögliche Kompression aufgezeigt ist. Der ursprüngliche Kode sei z.B. einen 5-Bit Dual-Kode, mit einer O als Start-Zeichen und einem L als Stop-Zeichen. Die Signalfolge L, O ist also jeweilen als Trennzeichen zwischen 2 Pulspakete eingeschoben.

In der linken Kolonne (I) sind alle die $2^5 = 32$ möglichen Pulsgruppen zusammen mit dem Start- und dem Stop-Signal dargestellt,und in der rechten Kolonne (II) sind die entsprechenden Pulsgruppen des konzentrierten Kodes dargestellt, mittels dem sich die Erfindung realisieren lässt.

Dabei wird als Trennzeichen die Zeichenelementkombination LL verwendet. Damit die Erkennung des Trennzeichens sichergestellt ist, sind demzufolge Kodegruppen, die mit L beginnen, nicht zulässig. Sämtliche Kodegruppen beginnen also mit O. Ferner weist aus dem genannten Grund keine der Kodegruppen die Kombination LL am Ende auf. Schliesslich enthält keine der Kodegruppen die Folge LLO.

Dies erlaubt es, zur Paketerkennung im komprimierten Pulszug jeweils die Folge LLO zu detektieren. Die Kodepaketlänge (Buchstabenlänge) kann dabei beliebig sein, da ja die Kombination LL die Pakete eindeutig trennt; sie soll jedoch der gestellten Aufgabe entsprechend minimal sein.

Es ist ersichtlich, dass alle Kodepakete der Kolonne II diesen Bedingungen genügen; das Trennzeichen (hier also LL), ist wie in Kolonne I ebenfalls dargestellt, aber der Uebersichtlichkeit wegen jeweilen zu Beginn eines jeden Pulspaketes, und nicht aufgeteilt in einen Start- bzw. Stopschirtt, wie bei Kolonne I.

Die Vorschriften der Kodegestaltungen fussen auf der Tatsache, dass die Trennzeichen eindeutig erkennbar sein müssen, da ja variable Buchstabenlängen vorkommen und nur noch der Zeichenelementtakt existiert, wogegen beim Urkode sowohl der Zeichenelementtakt, wie das 7-fache Multiple davon, der Buchstabentakt, fest gegeben sind.

Wie sich durch einfache Rechnung ergibt, umfasst Kolonne I insgesamt $(35 \cdot 5) + (32 \cdot 2) = 224$ Bit. Kolonne II andererseits weist $(6 \cdot 6) + (12 \cdot 5) + (7 \cdot 4) + (4 \cdot 3) + (2 \cdot 2) + (1 \cdot 1) + (32 \cdot 2) = 205$ Bit auf, also 19 Bit weniger als Kolonne I.

Um nun eine zusätzliche Information in den Impulszug einschlaufen zu können, ist beim dargestellten Ausführungsbeispiel ein Pulspaket von 7 Bit-Länge (plus die LL als Trennzeichen), also ein Zwischenraum von 9 Bit nötig, da ja fast alle Pulspaketlängen mit weniger als 7 Bit beim Kode nach Kolonne II schon belegt sind. Im statistischen Mittel wird es also möglich sein, jeweilen nach 16 Pulspaketen ein Zusatz-Signal zu 9 Bit einzuschlaufen, wenn die im Beispiel dargestellte Kodewandlung ausgeführt wird.

In der Praxis hat man es nun aber kaum mit einem beliebigen Impulsstrom zu tun, dessen Struktur absolut unbekannt ist; vielmehr ist je nach vorliegenden Bedingungen die Strukturierung des zu übertragenden Impulszuges bekannt, denn es existiert heute eine beschränkte Anzahl von genormten Datenalphabeten.

Eine komplizierte Analyse der vorerst unbekannten Strukturierung des zu verarbeitenden Impulszuges ist deshalb nicht nötig. Eine solche ist jedoch ohne weiteres realisierbar, sofern bekannt ist, unter welcher gegebenen Auswahl von möglichen Datenverarbeitungsalphabeten zu unterscheiden ist. Das entsprechende Gerät ist dazu mit einer automatisch wirkenden Korrelationsschalungsanordnung zu versehen, die bei Betriebsaufnahme systematisch den zu verarbeitenden Impulsstrom auf die verschiedenen bekannten, in der Korrelationsschaltung vorprogrammierten Datenalphabete abfrägt und bei Uebereinstimmung ein Kennsignal abgibt.

Liegt ein zum vornherein bekanntes Alphabet vor, so kann dieses mit einem Wählschalter beim Einschlaufen des Gerätes in die Verarbeitungsstrecke am Gerät eingestellt werden.

Die Pulspakete können dabei allerdings erhebliche Längen (z.Zt. bis zu 1024 Bit) aufweisen, und die entsprechenden Umkodiersysteme, die vorzugsweise in Form von Festwertspeichern realisiert werden, sind demgemäss ziemlich umfangreich. Wie aber eingangs erwähnt, liegen bei der Bild-Telegraphie gleiche Bedingungen vor. Technische Lösungen hierzu sind dem Fachmann bekannt.

Ist aber die Struktur des zu verarbeitenden Impulsstroms bekannt, so ist es vorteilhaft, die Umkodierung so vorzunehmen, dass den Pulspaketen, welche im bezüglichen Datenverarbeitungsalphabet häufiger als andere vorkommen, diejenigen "neuen" Kodepakete zugeordnet werden, die eine kleine Anzahl Bit oder Zeichenschritte umfassten.

Im vorliegenden Beispiel wären z.B. die Zeichen Nr. 5 und 17 der linken Kolonne als erste zu betrachten; diese entsprechen im internationalen Fernschreibkode CCITT Nr. 2, dem Zeichen "Zwischenraum", bzw. dem Buchstaben "E", deren Häufigkeit in den Sprachen, die dieses Alphabet benützen, an erster Stelle liegen.

Man teilt also z.B. dem Zeichen Nr. 5 vorzugsweise die Kombination O und dem Zeichen Nr. 17 die Kombination OO zu.

Als nächstes kann mit absteigender Häufigkeit im vorliegenden Datenalphabet die Kombination OL, dann die 3er-Kombinationen usw. belegen werden. Das Resultat ist eine Konzentration, die einen grösseren "Wirkungsgrad" ausweist.

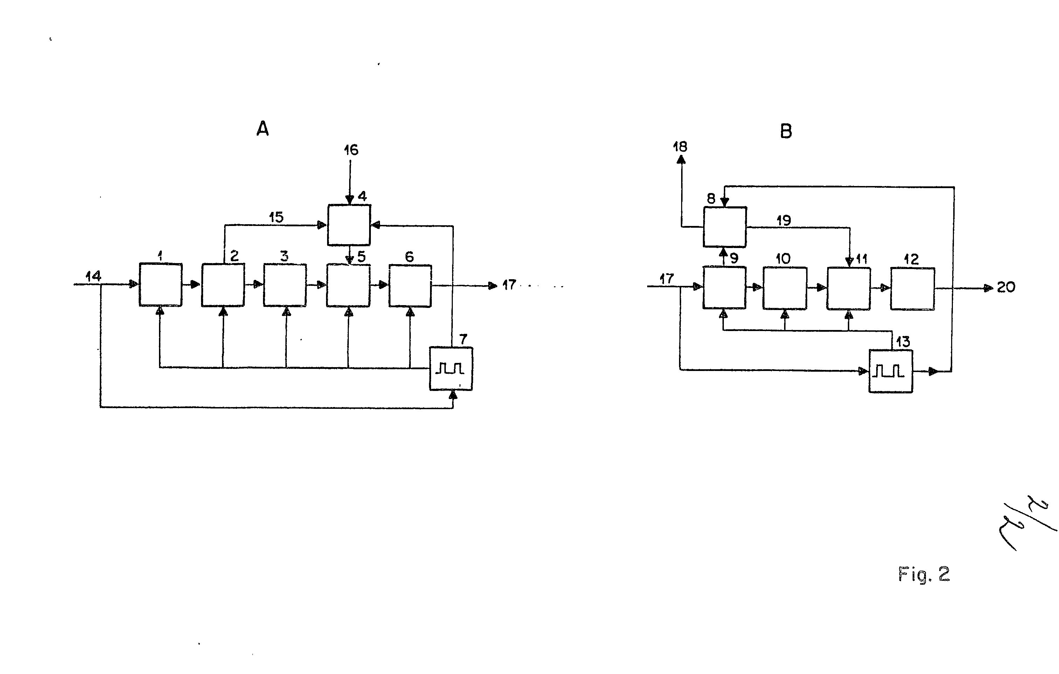

In der Folge sei nun anhand des Blockschaltbildes in Fig. 2 der Aufbau eines Ausführungsbeispiels einer Uebertragungsstrecke mit einer solchen aus zwei Geräten bestehenden Anlage schematisch dargestellt. In der Praxis wird in der Regel ein Gerät meist sowohl die sendeseitigen, wie auch die empfangsseitigen Merkmale in sich vereinigen, da ja heute übliche Datenübertragungssysteme meist in beiden Richtungen arbeiten. Um die Darstellung übersichtlich zu gestalten, wurde das Beispiel auf eine Uebertragungsrichtung reduziert. Es ist dem Fachmann jedoch ohne weiteres möglich, die Ergänzungen zum wechselseitigen Betrieb vorzunehmen. Die Uebertragung arbeitet im Synchronverfahren und es wird vorausgesetzt, dass beim "Einpfeifen" der ganzen Strecke in bekannter Weise auch die hier spezifischen Funktionen eingespielt werden, um anschliessend Bereitschaft für den eigentlichen Uebermittlungsbetrieb zu erstellen.

Im Blockschaltbild Fig. 2 ist mit (A) die sendeseitige Station und mit (B) die empfangsseitige Station gekennzeichnet. In der Uebertragungsstrecke sind jeweilen mindestens zwei Kodewandler 2 bzw. 11 vorhanden, wobei derjenige auf der Sendeseite (A) die vorgehend geschilderten Funktionen ausführt und das auf der Empfangsseite (B) eingeschlaufte Gerät einerseits eine Rückkodierung der Information in das ursprünglich vorliegende Datenalphabet vornimmt und allfällig auf der Sendeseite eingeschlaufte, zusätzliche Signale abzweigt und einer separaten Signalleitung 18 zuführt. Im weiteren sei erwähnt, dass die Realisation einer solchen Anlage sich nicht auf dual-Kode beschränkt, ternäre oder noch höherwertige Kodes sind auch erfassbar.

Die Information kommt von einer nicht näher umschriebenen Datenquelle über eine Leitung 14 zum Empfänger 1 und von da zum Kodewandler 2; dieser kann entweder einen von Hand umstellbaren Umschalter für die zur Auswahl vorliegenden verschiedenen Datenalphabete aufweisen, oder eine Auto-Korrelationsvorrichtung, die z.B. ähnlich aufgebaut sein kann, wie die Anordnung nach CH-Patent Nr. 581'930. Jene Vorrichtung erlaubt es, aus einem strukturierten Impulszug heraus die Trennsignale herauszufinden. Sie ist lediglich dadurch zu ergänzen, dass alle verschiedenen, allfällig vorkommenden Datenalphabetstrukturen verarbeitet werden können, (statt nur eines Alphabetes), wobei bei derjenigen mit kürzester Buchstaben- bzw. Wortlänge begonnen wird und nach einer vorbestimmten Zeit eines Suchlaufes, bei nicht erfolgter Detektion der angenommenen Struktur ein Suchlauf für das nächste Alphabet durchgeführt wird. Ist einmal die Strukturierung erkannt, so erfolgt entsprechende Befehlsausgabe an den eigentlichen Kode-Wandler mit entsprechender Abgabe eines Kenn-Signals über eine Steuerleitung 15, das für den gewählten, eben durch die Korrelation ermittelten Ur-Kode kennzeichnend ist. Bei Handauswahl wird dieser Umschalter gleich zu Arbeitsbeginn entsprechend richtig geschaltet.

Der Empfänger führt vorzugsweise eine, in der Fernmeldetechnik heute übliche Serie-Parallelwandlung und allfällige Zwischenspeicherung durch; auf spezielle Lösungshinweise wird verzichtet, da die technischen Realisationen heute dem Fernmeldefachmann bekannt sind.

Im Kodewandler 2 erfolgt die Umwandlung des vorliegenden Kodes von gleichlangen Impulspaketen in einen Kode mit variablen Paketlängen, wie beispielsweise in Fig. 1 dargestellt.

Die entsprechenden Zeichen (Fig.1, Kolonne II) werden in den Speicher 3 eingeschoben.

In einer Mischstufe 5 werden die zusätzlich zu übermittelnden Signale, die in den Hilfsspeicher 4 über eine Leitung 16 eingegeben werden, in den vom Hauptspeicher 3 kommenden Informationsfluss eingeschlauft, sobald jeweilen im Sinne der früheren Erläuterungen dafür ein Platz frei wird. Ein Sender 6 sorgt für entsprechende Umformung der Information, die an Uebertragungsleitung 17 abgegeben wird.

Besitzt der Kode-Wandler 2 eine automatisch arbeitende Kodeauswahlschaltung, so wird als erstes Zusatzsignal das, dem gefundenen Kode zugeordnete Kennsignal, wie weiter vorn erwähnt, über die Leitung 15 abgegeben und im Zusatzspeicher 4 gelagert. Als erstes einzuschlaufendes Signal wird der Zusatzspeicher 4 in solchen Fällen dieses Kennsignal an die Mischstufe 5 zur Uebermittlung an den Sender 6 abgegeben. Die Uebertragungsleitung 17 zum Empfänger kann auch eine drahtlose Verbindung umfassen. Die gesamte Einrichtung ist durch einen Taktgeber 7 so gesteuert, dass der zeitlich richtige Ablauf gewährleistet ist. Dieser Taktgeber 7 übernimmt von der Leitung 14 den Urtakt des Impulsstromes, da ja der gesamte Betrieb stets im gleichen Taktrahmen ablaufen muss.

Auf eine nähere Beschreibung des Aufbaus der einzelnen Funktionsstufen wird verzichtet, sie sind heute dem Fachmann allgemein bekannt.

Beim Empfänger B kommen die Impulszüge über die Leitung 17 herein; in der Empfangs-Trennstufe 9 werden die eingeschobenen, dem reduzierten Datenkode nicht zugehörigen Zusatzsignale erkannt, ausgeschieden und in einen Hilfsspeicher 8 eingegeben, aus welchem sie über die Leitung 18 weitergeleitet werden. Als erstes bei Betriebsaufnahme wird allerdings bei automatisch erfolgter Urkode-Detektion durch die Trennstufe 9 das entsprechende Kode-Kennsignal, das durch die Mischstufe 5 eingeschlauft wurde, erkannt und nicht an die Leitung 18, sondern über die Verbindung 19 an den Kode-Rückwandler 11 abgegeben.

Die übrigen im reduzierten Datenkode übertragenen Signale werden dem Hauptspeicher 10 zugeführt; von da gelangen sie zum Kode-Rückwandler 11. Ist dieser manuell geschaltet, so erfolgt die Kode-Rückwandlung unmittelbar; liegt auf der Sendeseite eine automatische Urkode-Detektion vor, so wird der Wandler vorerst durch das via Verbindung 19 zugeleitete Kennsignal auf den zu treffenden Urkode eingestellt, was, wie erläutert, bei Betriebsaufnahme erfolgt, und anschliessend kann die eigentliche Uebermittlung stattfinden. Am Ausgang 20 erscheinen die durch den Sender 12 geformten Zeichen empfangsseitig in richtiger Anordnung und Form wieder, wie sie am sendeseitigen Eingang 14 eingespeist worden sind.

Im Hilfsspeicher 8 allfällig eingespeicherte Zusatzzeichen sind über die Leitung 18 verfügbar, wobei deren Uebermittlung jeweilen eine bestimmte Zeitspanne voraussetzt, wie dies weiter vorn erläutert worden ist.

Der empfangsseitige Taktgeber 13 steuert den richtigen Ablauf in der empfangsseitigen Station B, wobei er sich auf die Taktfrequenz der über die Leitung 17 eintreffenden Impulse abstützt, wodurch wiederum gewährleistet ist, dass die ursprüngliche Taktfrequenz beibehalten wird.

PATENTANSPRUECHE

1. Einrichtung zum Uebertragen zusätzlicher Information bei gleichbleibender Grundtaktrate in einem Uebertragungssystem, wobei die ursprüngliche Information in einem Kode mit digitalen, strukturierten, gleichlangen und durch sendeseitig eingegebene Trennzeichen begrenzten Impulspaketen vorliegt, die im statistischen Mittel eine gleichmässige Verteilung der verschiedenen Zustandslagen aufweisen, mit je einem sendeseitigen (A) und einem empfangsseitigen (B) Gerät, das jedes mindestens einen Datenempfänger (1;9), einen Speicher (3;10),einen Datensender (6;12) sowie einen Taktgeber (7;13) enthält, dadurch gekennzeichnet, dass sendeseitig ein Kode-Wandler (2) vorhanden ist, der die sendeseitig eingegebene, ursprüngliche Information in einen Kode umwandelt, der ungleichlange Impulspakete umfasst, jedoch im statistischen Mittel weniger Impulse für eine gegebene Meldungslänge benötigt, dass ferner eine Mischstufe (5) vorhanden ist, die sendeseitig aus einem weiter vorhandenen Hilfsspeicher (4), nach Massgabe der erzielten Impulseinsparung bei gleichbleibender Grundtaktrate zusätzliche Impulspakete auf die Uebertragungsleitung einschlauft, und dass empfangsseitig eine Trennstufe (9) vorhanden ist, die diese zusätzlich übertragenen Signale ausscheidet und an einen ebenfalls empfangsseitig vorhandenen Hilfsspeicher (8) abgibt, und dass weiter empfangsseitig ein Kode-Rückwandler (11) existiert, der die restlichen, verbleibenden Impulspakete in die ursprüngliche, sendeseitig eingegebene Information zurückverwandelt.

2. Einrichtung nach Anspruch 1, dadurch gekennzeichnet, dass der Kode-Wandler (2) mit einem selbsttätigen Korrelator verbunden ist zur automatischen Ermittlung bei Betriebsaufnahme des Kodes der seindeseitig eingegebenen, ursprünglichen Information aus einer Auswahl vorgegebener, unterschiedlicher Uebertragungskodes und zur Einstellung des Kodewandlers (2) auf den ermittelten Kode, dass der Korrelator zugleich mit dem Hilfspeicher (4) verbindbar ist zur Eingabe eines ersten, zusätzlich zu übertragenden Kennsignals, welches dem ermittelten Kode zugeordnet ist, und dass der empfangsseitige Kodewandler(11) nach Eintreffen dieses Kenn-Signals vom empfangsseitigen Hilfsspeicher (8) auf das entsprechende Kode-Rückwandlungsverfahren einstellbar ist.

3. Einrichtung nach Anspruch 1, dadurch gekennzeichnet, dass der sendeseitige Kodewandler ( 2) manuell auf den Kode der sendeseitig eingegebenen, ursprünglichen Information einstellbar und gleichzeitig mit dem Hilfsspeicher (4) verbindbar ist zur Eingabe eines ersten, zusätzlich zu übertragenden Kenn-Signals, welches dem eingestellten Kode zugeordnet ist, und dass der empfangsseitige Kodewandler (11) nach Eintreffen dieses Kenn-Signals vom empfangsseitigen Hilfsspeicher (8) auf das entsprechende Kode-Rückwandlungsverfahren einstellbar ist.

4. Verfahren zum Betrieb der Einrichtung nach Anspruch 1, dadurch gekennzeichnet, dass jedem ursprünglichen, sendeseitig eingegebenen Impulspaket im Kodewandler (2) ein zu übertragendes Impulspaket zugeordnet wird, wobei die zu übertragenden Impulspakete variable Längen aufweisen und durch eindeutig erkennbare Trennzeichen (LL), die nicht vom Grundtakt abweichen getrennt sind, so dass im statistischen Mittel weniger Impulse für eine gegebene Meldungslänge benötigt werden, dass sendeseitig beim Vorliegen ausreichender Lücken zusätzliche Impulspakete eingefügt werden und danach die Uebertragung an die Empfangsseite (B) erfolgt, wobei empfangsseitig die zusätzlichen Impulspakete abgetrennt und die restlichen Impulspakete im Kode-Rückwandler (11) in ihre ursprüngliche Form gebracht werden.

5. Verfahren nach Anspruch 4, dadurch gekennzeichnet, dass sendeseitig vor der Kodewandlung der Kode der ursprünglichen, sendeseitig eingegebenen Information durch Vergleich mit einer Anzahl möglicher, vorgegebener Kodes ermittelt wird, wobei zunächst diejenigen mit kurzen Impulspaketen mit der eingegebenen Information verglichen werden, und dass nach Auffinden des betreffenden Kodes der sendeseitige Kodewandler (2) darauf eingestellt wird.

|  | I |  | II |
|---|---|---|---|
| 1 | oOOOOOL |  | LLO |
| 2 | oOOOOLL |  | LLOO |
| 3 | oOOOLOL |  | LLOL |
| 4 | oOOOLLL |  | LLOOO |
| 5 | oOOLOOL |  | LLOLO |
| 6 | oOOLOLL |  | LLOOL |
| 7 | oOOLLOL |  | LLOLL |
| 8 | oOOLLLL |  | LLOOOO |
| 9 | oOLOOOL |  | LLOLOO |
| 10 | oOLOOLL |  | LLOOLO |
| 11 | oOLOLOL |  | LLOOOL |
| 12 | oOLOLLL |  | LLOLOL |
| 13 | oOLLOOL |  | LLOOLL |
| 14 | oOLLOLL |  | LLOLLL |
| 15 | oOLLLOL |  | LLOOOOO |
| 16 | oOLLLLL |  | LLOLOOO |
| 17 | oLOOOOL |  | LLOOLOO |
| 18 | oLOOOLL |  | LLOOOLO |
| 19 | oLOOLOL |  | LLOOOOL |
| 20 | oLOOLLL |  | LLOLOLO |
| 21 | oLOLOOL |  | LLOLOOL |
| 22 | oLOLOLL |  | LLOOLOL |
| 23 | oLOLLOL |  | LLOOOLL |
| 24 | oLOLLLL |  | LLOLOLL |
| 25 | oLLOOOL |  | LLOOLLL |
| 26 | oLLOOLL |  | LLOLLLL |
| 27 | oLLOLOL |  | LLOOOOOO |
| 28 | oLLOLLL |  | LLOLOOOO |
| 29 | oLLLOOL |  | LLOOLOOO |
| 30 | oLLLOLL |  | LLOOOLOO |
| 31 | oLLLLOL |  | LLOOOOLO |
| 32 | oLLLLLL |  | LLOOOOOL |

$\Sigma = 224$ Bit          $\Sigma = 205$ Bit

Fig. 1

A

B

Fig. 2

0023274

**Europäisches Patentamt**

## EUROPÄISCHER RECHERCHENBERICHT

Nummer der Anmeldung
EP 80 10 3702

| | EINSCHLÄGIGE DOKUMENTE | | KLASSIFIKATION DER ANMELDUNG (Int Cl ) |
|---|---|---|---|
| Kategorie | Kennzeichnung des Dokuments mit Angabe, soweit erforderlich, der maßgeblichen Teile | betrifft Anspruch | |
| D | I.E.E.E. TRANSACTIONS ON INFORMA-TION THEORY, Band IT-17, Nr. 4, Juli 1971, Seiten 500-503 New York, U.S.A. WALLINGFORD et al.: "Simple Data Compression by Redundancy Replacement" <br> * Seite 501, linke Spalte, Zeilen 24-37 * <br> -- | 1,4 | H 04 L 25/16 |
| D | BELL TELEPHONE SYSTEM TECHNICAL PUBLICATIONS, Monograph 4259 September 1962, Seiten 1-7 New York, U.S.A. NEUMANN: "On a Class of Efficient Error-Limiting Variable-Length Codes" <br> * Seite 2, linke Spalte, letzter Abschnitt * <br> -- | 1,4 | RECHERCHIERTE SACHGEBIETE (Int Cl ) <br> H 04 L 25/16 <br> 3/04 <br> 25/49 |
| D | US - A - 3 016 527 (GILBERT et al.) <br> * Spalte 1, Zeilen 43-46; Spalte 2, Zeilen 43-65; Spalte 5, Zeilen 2-20 * <br> -- | 1,4 | |
| D | US - A - 4 099 257 (ARNOLD et al.) <br> * Spalte 2, Zeilen 51-61; Spalte 3, Zeilen 7-13; Spalte 6, Zeile 43 - Spalte 7, Zeile 2 * <br> -- | 2 | KATEGORIE DER GENANNTEN DOKUMENTE <br> X: von besonderer Bedeutung <br> A: technologischer Hintergrund <br> O: nichtschriftliche Offenbarung <br> P: Zwischenliteratur <br> T: der Erfindung zugrunde liegende Theorien oder Grundsätze |
| D | FR - A - 1 487 626 (ELECTRONIC IMAGE SYSTEMS) <br> * Seite 2, rechte Spalte, Zeilen 40-55; Seite 4, linke Spalte, Zeilen 49-55; Seite 10, rechte Spalte, zwei letzte Zeile - | 2 | E: kollidierende Anmeldung <br> D: in der Anmeldung angeführtes Dokument <br> L: aus andern Gründen angeführtes Dokument <br> &: Mitglied der gleichen Patentfamilie, übereinstimmendes Dokument |

./.

Der vorliegende Recherchenbericht wurde für alle Patentansprüche erstellt.

| Recherchenort | Abschlußdatum der Recherche | Prüfer |
|---|---|---|
| Den Haag | 31-10-1980 | HOLPER |

EPA form 1503.1  06.78

BAD ORIGINAL

Europäisches
Patentamt

**EUROPÄISCHER RECHERCHENBERICHT**

| | EINSCHLÄGIGE DOKUMENTE | | KLASSIFIKATION DER ANMELDUNG (Int Cl 3) |
|---|---|---|---|
| Kategorie | Kennzeichnung des Dokuments mit Angabe, soweit erforderlich, der Maßgeblichen Teile | betrifft Anspruch | |
| | Seite 11, linke Spalte, Zeile 9; Seite 12, linke Spalte, Zeile 37 - rechte Spalte, Zeile 3 * | | |
| | ---- | | |
| | | | RECHERCHIERTE SACHGEBIETE (Int. Cl.3) |